# EUROPEAN PATENT APPLICATION

(11) **EP 1 071 095 A2**
(43) Date of publication of application: **24.01.2001**
(21) Application number: 00114976.4
(22) Date of filing: 20.07.2000
(51) Int. Cl.: G11C 7/22, G11C 7/10

(54) **Memory acces method and system**

(30) Priority: 22.07.1999 JP 20712699
(71) Applicant: NEC CORPORATION, Tokyo (JP)
(72) Inventor: Tsuda, Hiroki, Minato-ku, Tokyo (JP)
(74) Representative: VOSSIUS & PARTNER

(57) **Abstract**

A memory access method and system which solve problems of degradation of data transfer efficiency due to memory access waiting period and complexity of memory interface. The system has an address buffer for reading an address in synchronization with a clock, a burst counter which generates an address of burst length; a ROW address register for timing adjustment by latching a ROW address; a COLUMN address register for timing adjustment by latching a COLUMN address; a ROW address decoder which decodes the ROW address; a COLUMN address decoder which decodes the COLUMN address; a mode register in which an operation mode of a DRAM is set; a command decoder which interprets and discriminates a command by a control signal; a controller which controls an operation of the overall DRAM; a memory array for holding data; and a data input/output buffer for data transmission/reception.

## Description

The present invention relates to a memory access method and system and, more particularly, to a memory access method and system for writing and reading with respect to a synchronous dynamic random access memory (SDRAM) and control thereof.

Generally, a dynamic random access memory (DRAM) with a simple information storage structure has a memory capacity larger than that of a static random access memory (SRAM).

However, upon random writing/reading access, as a ROW address and a COLUMN address are set in a time-multiplexing manner, the data transfer speed is low.

Accordingly, if a high data transfer speed is required, a synchronous type DRAM (SDRAM) which realizes high-speed access by pipeline processing is utilized. In case of access to a page of the same ROW address, an access speed equivalent to that of SRAM can be attained.

However, since the SDRAM is based on the DRAM basic operation, if writing with the same ROW address changes to reading or if writing/reading to/from some page is made and then writing/reading is made to/from another page, there is a period where the data bus is not effectively used, and the data transfer efficiency is lowered.

Further, in such operation, as well as the lowered data transfer efficiency, a problem occurs in communication application to perform continuous data writing/reading by random access. That is, upon access to a memory, a waiting period occurs, or the necessity of temporary data storage in such waiting period complicates the memory interface.

These problems will be described more specifically.

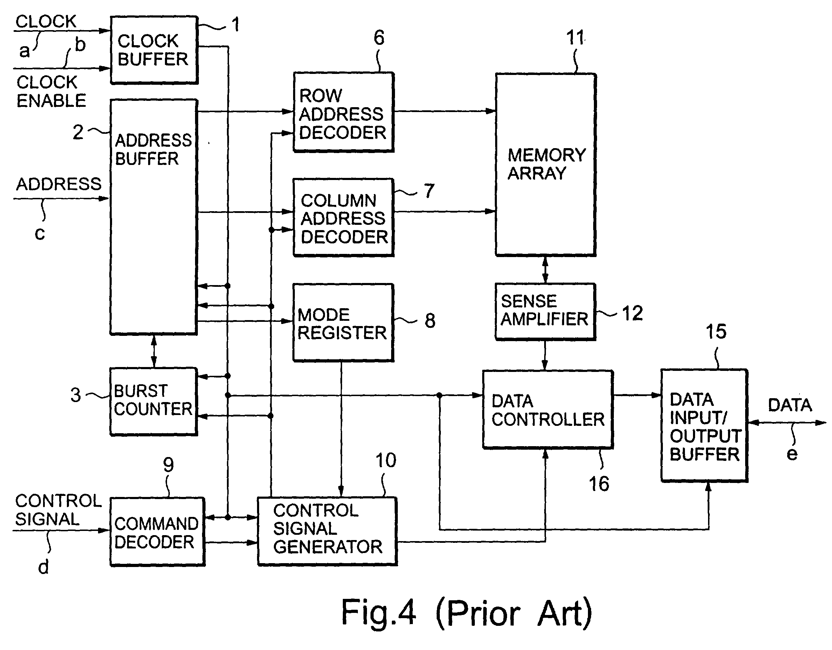

Fig. 4 is a block diagram showing a general SDRAM (Synchronous DRAM). The schematic operation of the general SDRAM having this construction will be described.

A command decoder 9 determines the type of command by a command signal d inputted from the outside. If the command decoder 9 interprets the type of command as "raw address setting (ACT)", an address c inputted from the outside is latched in an address buffer 2, and outputted to a ROW address decoder 6.

On the other hand, if the command decoder 9 interprets the type command as "writing (WR)" or "reading (RD)", the address c inputted from the outside is latched in the address buffer 2, and outputted to a COLUMN address decoder 7.

Further, if the command decoder 9 interprets the type of command as "mode setting", the address c inputted from the outside is latched in the address buffer 2, and outputted to a mode register 8.

A control signal generator 10 generates a control signal based on the setting of the mode register 8 so as to operate respective elements of the DRAM on the condition set by the mode register 8, thus controlling the respective elements of the DRAM, i.e., the address buffer 2, a burst counter 3, the ROW address decoder 6, the COLUMN address decoder 7 and a data controller 16.

Among the parameters set in the mode register 8, a burst length and a burst address reading order are set to determine the operation condition for the burst counter 3.

The burst length and the burst address reading order are set through the address buffer 2 from an address signal input a after the power is turned on. The control signal generator 10 controls the burst counter 3 in accordance with the set burst length and the burst address reading order.

The burst counter 3 generates a series of addresses for burst transfer from the input address in accordance with the burst length and the burst address reading order controlled by the control signal generator 10, and outputs the series of addresses through the address buffer 2 to the ROW address decoder 6.

The ROW address decoder 6 and the COLUMN address decoder 7 decode a ROW address and a COLUMN address respectively inputted from the address buffer 2, and select a memory cell to/from which data is to be written or read, from a memory array 11.

The control signal generator 10 controls the data controller 16 by the control signal generated in correspondence with the command inputted from the command decoder 9, to store data e inputted through a data input/output buffer 15 into the selected memory cell in the memory array 11. Further, if the input command from the command decoder 9 is "reading", the controller 16 reads information from the selected memory cell in the memory array 11, and outputs the information from the data input/output buffer 15 through a sense amplifier 12.

The burst counter 3 generates a burst transfer address from the burst length and the burst address reading order set in the mode register 8. The memory cell in the memory array 11 designated by the ROW address decoder 6 and the COLUMN address decoder 7 is selected from the ROM address and the COLUMN address. The data controller 16 is controlled by the control signal generated by the control signal generator 10 in correspondence with the command from the command decoder 9. If the command from the command decoder 9 is "writing", the data e inputted through the data input/output buffer 15 is stored into the selected memory cell in the memory array 11.

Further, if the command from the command decoder 9 is "reading", the information is read from the selected memory cell in the memory array 11, and the information is outputted from the data input/output buffer 15 through the sense amplifier 12.

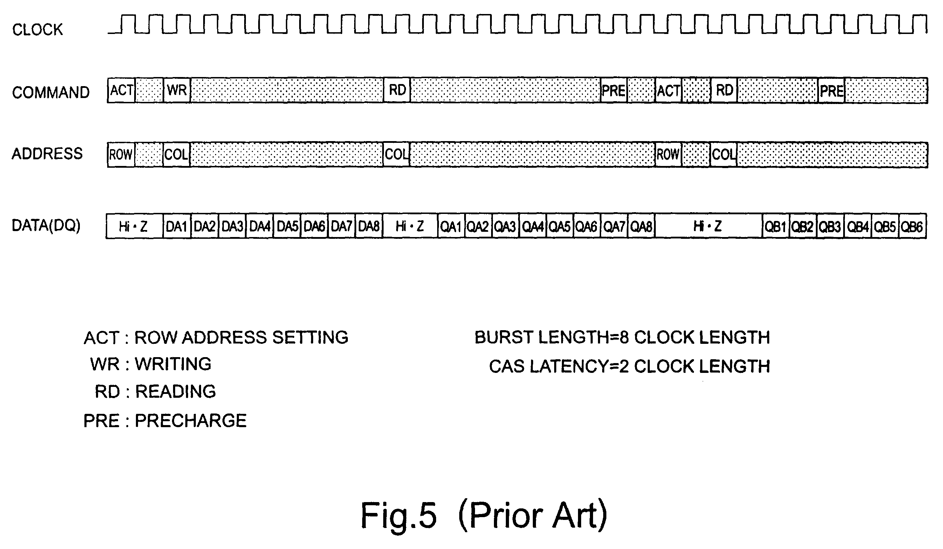

Fig. 5 shows access timing in the above operation. Fig. 5 shows an example of access operation on the condition that the burst length is 8 clock length, and a COLUMN address strobe (CAS) latency is 2 clock length. A combination of control signals for execution of processing is called a command. When processing is switched from writing to reading, data on the data bus (D) is stored into the memory upon setting of writing (WR) command, on the other hand, upon reading (RD) of information from the memory, after the execution of command, the information is outputted onto the data bus with delay of clock length of the CAS latency. Accordingly, a period where the data bus is not used exists between the writing processing and the reading processing.

In a case where some ROW address is set (ACT) then writing (WR) or reading (RD) processing is performed, and writing (WR) or reading (RD)is performed with different ROW address, precharging processing is performed to restore idle status, and a ROW address is newly set (ACT) and writing (WR) or reading (RD) is performed. Thus, a period where the data bus is not used exists during the writing or reading.

As described above, the present invention has its object to provide an SDRAM memory access method to reduce an idle period, where a data bus is not used, caused by access to a memory area with a different ROW address, by reservation registration and preparation for the execution of command to be executed next during a burst data writing/reading cycle, so as to increase data transfer efficiency and realize high speed burst data transfer, and to provide a simple memory interface.

The accompanying drawings, which are incorporated in and constitute a part of the specification, illustrate embodiments of the invention and, together with the description, serve to explain the principles of the invention.
Fig. 1 is a block diagram showing a memory access system according to an embodiment of the present invention;
Fig. 2 is a timing chart explaining memory access operation in the memory access system in Fig. 1;
Fig. 3 is a timing chart explaining command input operation;
Fig. 4 is a block diagram showing the construction of a conventional SDAM; and
Fig. 5 is a timing chart explaining the access operation of the conventional SDRAM.

A preferred embodiment of the present invention will now be described in detail in accordance with the accompanying drawings.

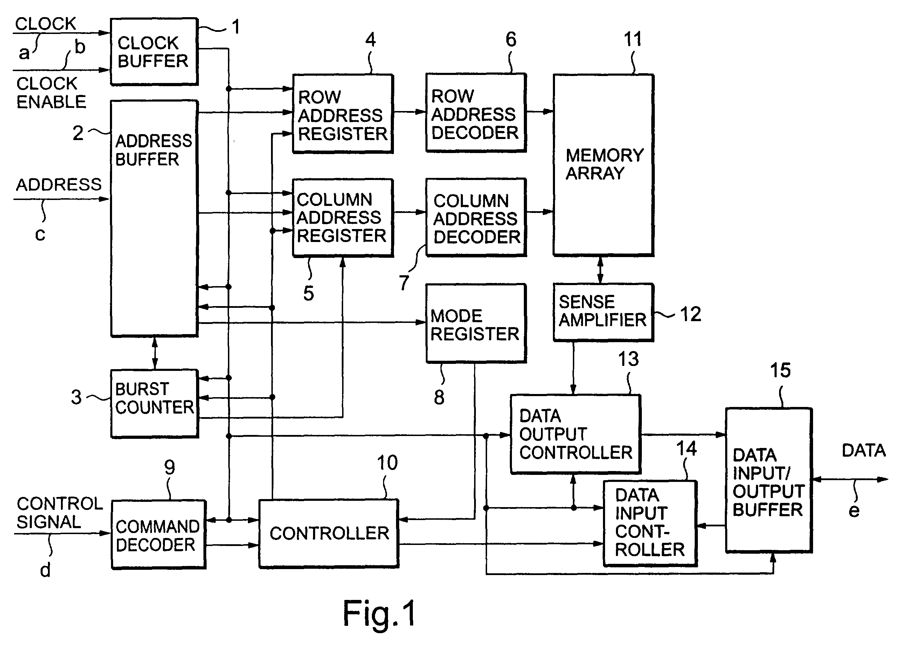

Fig. 1 is a block diagram of an SDRAM of a memory access system according to an embodiment of the present invention.

The memory access system has a clock buffer 1 which controls supply of clock signal a, inputted form the outside and delivers the signal to respective elements of the SDRAM so as to drive the elements, an address buffer 2 in which an address signal c or operation start pre-setting signal in synchronization with a rise of a clock signal outputted from the clock buffer 1, a burst counter 3 which generates a burst length address set upon burst data transfer to the outside, a ROW address register 4 in which a ROW address outputted from the address buffer 2 is latched for timing adjustment, a COLUMN address register 5 in which a COLUMN address outputted from the address buffer 2 is latched for timing adjustment, a ROW address decoder 6 which decodes the ROW address outputted from the ROW address register 4, a COLUMN address decoder 7 which decodes the COLUMN address outputted from the COLUMN address register 5, a mode register 8 in which an operation mode of the SDRAM is set, a command decoder 9 which interprets and determines a command by a control signal d, a controller 10 which controls the operation of the overall SDRAM in accordance with a command interpretation and determination signal outputted from the command decoder 9, a memory array 11 having a large number of memory cells for storing data e, a sense amplifier 12 which outputs the data e from a data input controller 14 to the memory array 11 and outputs data from the memory array 11 to a data output controller 13, the data output controller 13, controlled by a control signal outputted from the controller 10, which controls data output from the sense amplifier 12, a data input/output buffer 15 which transfers/receives the data e between the inside and the outside in synchronization with a clock signal from the clock buffer 1, and the data input controller 14, controlled by the control signal outputted from the controller 10, which controls input of the data e from the data input/output buffer 15.

Generally, before the SDRAM is used, its operation mode is set in the mode register 8 by address input. The setting is held until the mode is re-set or the power is turned off. The mode set in the mode register 8 is transmitted to the controller 10, and the controller 10 generates a control signal based on the mode and controls the respective elements of the SDRAM.

Upon input of address a and the control signal d, the command decoder 9 interprets the command type of the control signal d, and the controller 10 generates a control signal in correspondence with the determined command and outputs the signal.

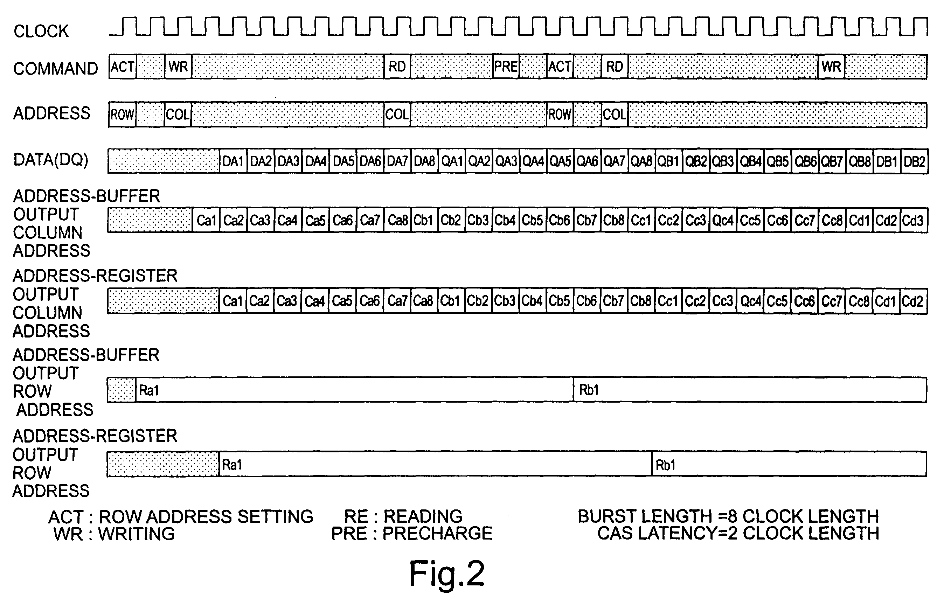

Fig. 2 is a timing chart on the condition that the burst length is 8 clock length and the COLUMN address strobe (CAS) latency is 2 clock length.

If the command decoder 9 interprets the command as "ROW address setting (ACT)", the input address a is latched in the address buffer 2, and is outputted to the ROW address register 4. If the command decoder 9 interprets the command as "writing (WR)" or "reading (RD)", the input address a is latched in the address buffer 2, and is outputted to the COLUMN address register 5.

In Fig. 2, a writing (WR) command is inputted following the ROW address setting (ADT). The ROW address is outputted from the ROW address register 4 to the ROW address decoder 6 in synchronization with the COLUMN address inputted upon writing. The timing-adjusted ROW address and the COLUNN address select a memory cell designated by the ROW address decoder 6 and the COLUMN address decoder 7 from a memory array 11.

If the data e is inputted with the writing command, the controller 10 prohibits output from the data output controller 13, and controls the dccc input controller 14 to receive the input data e through the data input/output buffer 15. The data e is stored from the data input controller 14 through the sense amplifier 12 into the selected memory cell in the memory array 11.

When burst first access information is written and held, the burst counter 3 generates an address of memory location for holding the information. The generated address is latched in the COLUMN address register 5 at the next clock, and is outputted to the COLUMN address decoder 7. Then the data e inputted through the input/output buffer 15 is stored into the memory selected by the address from the memory array 11, as in the case of the first access. Third to eighth accesses, information can be written into the memory, as in the case of the first and second accesses.

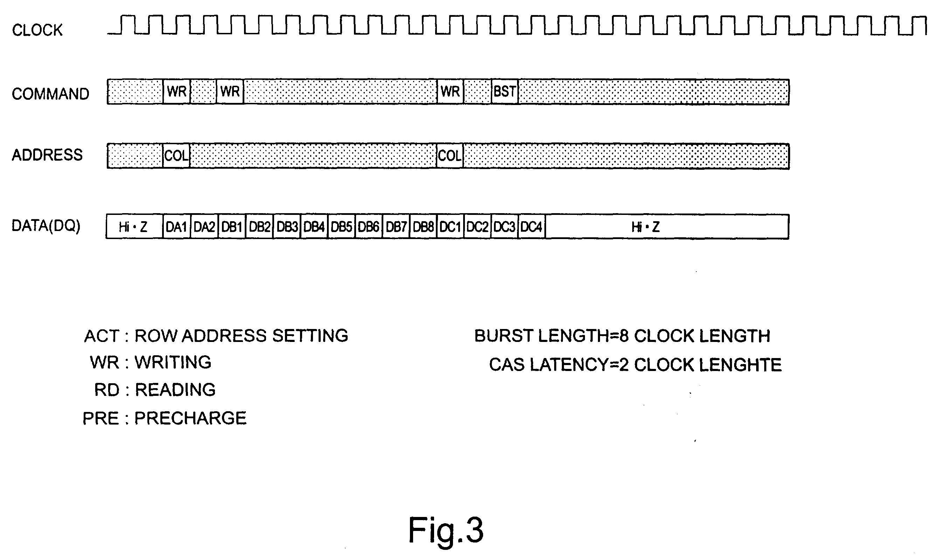

Generally, if a new command is inputted during a writing cycle as shown in Fig. 3, the execution stops, however, in the present invention, after a predetermined period from the input of writing command, new input of a writing (WR) command, a reading (RD) command and a precharge (PRE) command are executed after the completion of execution of already being executed command. That is, if a command is newly inputted while a current command is executed, the next execution is reserved for the new command, and preparation is made for quickly executing the new command. Note that a burst transfer operation can be terminated by a burst stop (BST) command.

In Fig. 2, during a writing (WR) cycle, a new reading (RD) command is inputted, and the next execution is reserved for the new command. The address inputted at the same time of the reading command is stored as a COLUMN address in the address buffer 2. When the newly-input reading command is executed, the COLUMN address is timing adjusted by the COLUMN address register 5 with the ROW address, and outputted to the COLUMN address decoder 7. Then, a memory cell designated by the ROW address and the COLUMN address is selected from the memory array 11, and the stored information is read through the sense amplifier 12.

That is, the controller 10 controls the output from the data input controller 14 to high impedance based on the reading command, and controls the output from the data output controller 13 to output the output data from the sense amplifier 12 from the data input/output buffer 15. The burst transfer from the second access with the reading (RD) command is similarly processed.

Similarly, regarding the precharging (PRE) and the following ROW address setting (ACT) and the reading (RD) command during a reading cycle, the execution of the input command is reserved, and the execution of the command is prepared by the completion of the currently-executed reading processing, and then sequentially executed after the completion of execution of the previous command.

That is, first, a memory cell in the memory array designated by the ROW address decoder 6 and the COLUMN address decoder 7 is selected, from the LOW address and the COLUMN address timing adjusted by the ROW address register 4 and the COLUMN address register 5. Next, the data input controller 14 and the data output controller 13 are controlled by a control signal generated by the controller 10 in accordance with a command from the command decoder 9. If the command is "writing", the data e inputted through the data input/output buffer 15 is stored into the selected memory cell in the memory array 11. Further, if the command is "reading", information is read from the selected memory cell in the memory array 11, and outputted from the data input/output buffer 15 through the sense amplifier 12 by controlling the output of the data output controller 13.

This operation may be realized by providing the mode register 8 with control information, and switching the operation of the conventional SDRAM with that of the embodiment of the present invention by the control information set in the mode register 8.

Further, in mode setting, if the latency of writing is different from that of reading, the mode setting information is inputted into the controller 10, and the controller 10 time controls the input controller 14 and the output controller 13 so as to bring the faster latency into correspondence with the slower latency.

According to the present invention relating to writing/reading to/from a dynamic random access memory and a control method and a system thereof, during a burst writing/reading cycle, reservation registration and execution preparation are made for a command to be executed next, and after the currently-executed cycle, the reserve-registered command is executed. This reduces an idle period where the data bus is not used upon access to a memory area with a different ROW address, and realizes a high data transfer speed.

In this burst access method, as the execution of the next command is reserved during a currently-executed cycle, a command input range is widened, and freedom occurs in input timing.

Further, latency of writing and that of reading different from each other are brought into correspondence, and upon execution of reading from writing, the idle period where the data bus is not effectively used is solved, and the memory data interface can be simplified.

By the access method and system, efficient and high-speed memory access can be provided in an application with a large number of continuous random writing and reading operations.

As described above, according to the present invention, upon access to a memory area with a different ROW address, an idle period where the data bus is not used is reduced, and a high data transfer speed can be attained. Further, latency of writing and that of reading different from each other are brought into correspondence, and upon execution of reading from writing, the idle period where the data bus is not effectively used is solved, and the memory data interface can be simplified.

As many apparently widely different embodiments of the present invention can be made without departing from the spirit and scope thereof, it is to be understood that the invention is not limited to the specific embodiments thereof except as defined in the appended claims.

## Claims

1. A memory access method comprising:
a step of discriminating an input command;
a step of, after discrimination of ROW address setting from said command, holding an input address as a ROW address for a predetermined period;
a step of, if writing or reading is discriminated from said command, holding an input address as a COLUMN address for a predetermined period; and
a step of selecting a memory cell based on the held ROW and COLUMN addresses.

2. The memory access method according to claim 1, further comprising a step of, when writing is performed in accordance with said command, inputting a new reading command and reserving execution of the newly input command during a writing cycle.

3. The memory access method according to claim 1 or 2, further comprising a step of, if latency of the writing and that of the reading have different values, adjusting a faster latency to a slower latency.

4. The memory access method according to claim 1, 2 or 3 wherein the memory is a synchronous DRAM (Dynamic Random Access Memory).

5. A memory access system comprising:
first holding means for, after discrimination of ROW address setting from said command, holding an input address as a ROW address for a predetermined period;
second holding means for, if writing or reading is discriminated from said command, holding an input address as a COLUMN address for a predetermined period; and
selection means for selecting a memory cell based on the held ROW and COLUMN addresses.

6. The memory access system according to claim 5, wherein the memory is a synchronous DRAM (Dynamic Random Access Memory).

7. A synchronous DRAM (Dynamic Random Access Memory) access system comprising:
an address buffer that reads an address signal or operation start pre-setting signal from outside in synchronization with an input clock;
a burst counter that generates an address of a burst length set upon burst data transfer with the outside;
a ROW address register that performs timing adjustment by latching a ROW address outputted from said address buffer;
a COLUMN address register that performs timing adjustment by latching a COLUMN address outputted from said address buffer;
a ROW address decoder that decodes the ROW address outputted from said ROW address register;
a COLUMN address decoder that decodes the COLUMN address outputted from said COLUMN address register;
a mode register that sets an operation mode of the DRAM by said operation start pre-setting signal;
a command decoder that interprets and discriminates a command by a control signal from the outside;
a controller that controls an overall operation of the DRAM in accordance with a command interpretation and discrimination result signal outputted from said command decoder;
a memory array having a large number of memory cells for holding data for burst data transfer with the outside;
a data output controller, controlled by a control signal from said controller, that controls output of said data from said memory array;
a data input/output buffer for transmission/reception of said data between the outside and inside, in synchronization with said input clock; and
a data input controller, controlled by the control signal outputted from said controller, that controls input of said data from said input/output buffer.
